# EUROPEAN PATENT SPECIFICATION

(11) **EP 0 402 851 B1**
(45) Date of publication and mention of the grant of the patent: **26.04.2000**
(21) Application number: 90111087.4
(22) Date of filing: 12.06.1990
(51) Int. Cl.: H01L 21/76

(54) **Semiconductor device including inversion preventing layers having a plurality of impurity concentration peaks in direction of depth and method of manufacturing the same**
Halbleiteranordnung mit die Inversion hemmenden Schichten mit einer Vielzahl von Höchstwerten für die Dotierungskonzentrationen entlang der Tieferichtung und Verfahren zu deren Herstellung
Dispositif semi-conducteur comportant des couches d'empêchement de champ d'inversion ayant une pluralité de matériau de concentration d'impuretés selon la direction en profondeur et son procédé de fabrication

(30) Priority: 14.06.1989 JP 15152789
(43) Date of publication of application: 19.12.1990
(73) Proprietor: KABUSHIKI KAISHA TOSHIBA, Kawasaki-shi, Kanagawa-ken 210-8572 (JP)
(72) Inventor: Taguchi, Minoru, c/o Intellectual Property Div., Minato-ku, Tokyo 105 (JP)
(74) Representative: Lehn, Werner, Dipl.-Ing.

(56) References cited:
- EP-A- 0 058 604
- EP-A- 0 073 942
- EP-A- 0 232 497
- GB-A- 2 206 446
- US-A- 4 013 484
- US-A- 4 692 992

## Description

The present invention relates to a CMOS or Bi CMOS semiconductor device.

A CMOS semiconductor device in which n- and p-channel MOSFETS are formed on a single chip is conventionally known. In addition, a Bi-CMOS semiconductor device obtained by adding a bipolar transistor to this CMOS semiconductor device is known. Recently, LSI manufacturing techniques, especially, unit techniques such as oxidation, diffusion, etching, and exposure have significantly progressed. In accordance with this progress, an occupation area per element on a chip has been decreased, and a packing density and an operation speed of an LSI have been increased. In the CMOS semiconductor device and the Bi-CMOS semiconductor device described above, micropatterning of an element has naturally progressed.

As micropatterning of an element has progressed, a film structure of an insulating film or a profile of an impurity concentration in a substrate, for example, in a semiconductor device has been largely improved to suppress generation of a leakage current, thereby ensuring reliability.

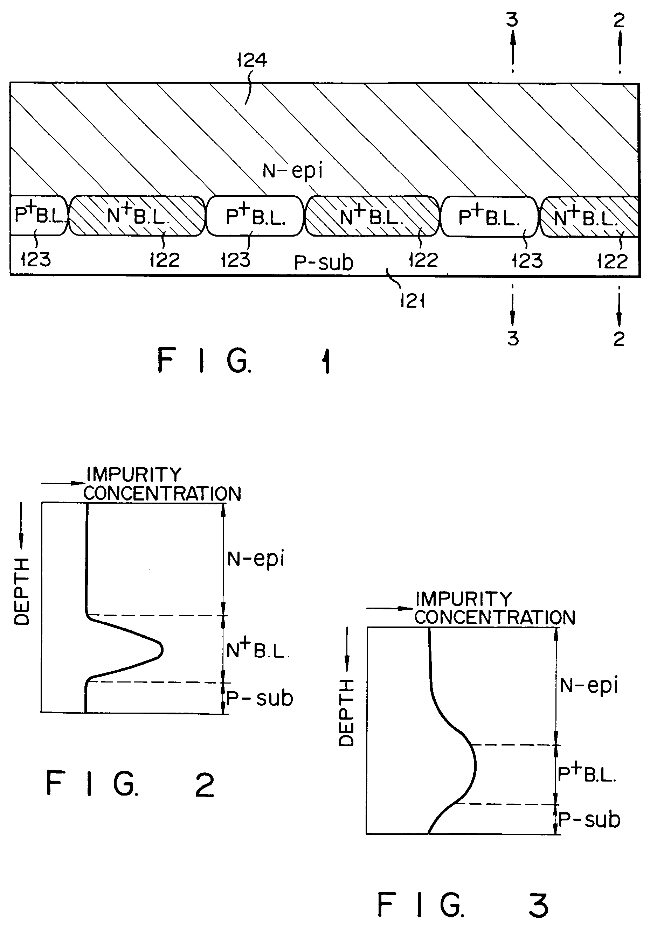

In recent years, however, the reliability of an apparatus for manufacturing an element cannot follow the rapid progress in micropatterning of an element. In particular, a parasitic pnpn structure is formed inside an element in the CMOS and Bi-CMOS semiconductor devices. This pnpn structure operates similarly to a thyristor to cause a latch-up phenomenon of the CMOS semiconductor device or a so-called field inversion phenomenon in which a semiconductor layer immediately below a field oxide film is inverted, thereby degrading the reliability of an element. Especially when a CMOS or Bi-CMOS semiconductor device having a micro element structure is manufactured by using a VG (Vapor Growth) wafer as shown in Fig. 1, a latch-up phenomenon caused by a parasitic pnpn structure significantly appears.

The VG wafer shown in Fig. 1 and its problems will be described below.

As shown in Fig. 1, n⁺-type buried layers A(N⁺B.L.) 122 and p⁺-type buried layers (P⁺B.L.) 123 are formed on a p-type semiconductor substrate 121, and a n-type epitaxial layer 124 is formed thereon.

In a method of manufacturing such a VG wafer, an oxide film or a photoresist is used as a mask to selectively vapor-phase-diffuse antimony (Sb) as an n-type impurity on the p-type semiconductor substrate 121, thereby forming the n⁺-type buried layers 122. Similarly, an oxide film or a photoresist is used as a mask to selectively vapor-phase-diffuse boron (B) as a p-type impurity to form the p⁺-type buried layers 123 on the substrate 121. The n-type epitaxial layer 124 is formed on the entire surface by a CVD method at a temperature of, e.g., 1,100°C to 1,250°C. During this formation, however, boron (B) having a high diffusion coefficient is unnecessarily diffused in the n-type epitaxial layer 124, resulting in a dull profile of an impurity concentration in the p⁺-type buried layers 123.

Fig. 2 shows a profile of an impurity concentration of a section taken along a line 2 - 2 in Fig. 1. For comparison, Fig. 3 shows a profile of an impurity concentration of a section taken along a line 3 - 3 in Fig. 1. As is apparent from Figs. 2 and 3, the impurity concentration of the p⁺-type buried layers 123 is decreased by growing the n-type epitaxial layer 124. When the impurity concentration of the layers 123 is decreased, insulating performance of the n⁺-type buried layers 122 formed in contact with the layers 123 is reduced to easily cause a latch-up phenomenon. In order to solve this problem, an impurity concentration of the p⁺-type buried layers 123 may be set higher in consideration of the fact that the profile of the impurity concentration becomes dull. In this case, however, a leak amount (unnecessary diffusion amount) of boron is further increased. An increase in boron leak amount adversely affects an active element formed in the n-type epitaxial layer 124. For example, a threshold value varies in a MOSFET, or a withstand voltage is reduced or an early voltage is degraded in a bipolar transistor.

The above phenomenon occurs not only when an n-type epitaxial layer is formed as described above but also when a p-type epitaxial layer is formed.

In addition, leakage of boron having a high diffusion coefficient into an epitaxial layer occurs not only during formation of the epitaxial layer but also during a heating step (normally at 1,100°C to 1,250°C) for forming a well region in an epitaxial layer (not shown). This makes it more difficult to solve the above problem.

US 4,013,484 describes a process for fabricating high density, high voltage CMOS devices. The process provides self-aligning, full channel stops which are formed prior to the fabrication of the active devices. The aligned full channel stops and a well are formed in the substrate without intermediate masking.

GB-2 206 446 describes a method for isolating adjacent semiconductor regions that results in first conductivity type buried regions being retracted with respect to second conductivity type regions. Thus, by forming second conductivity type regions as an epitaxial layer, impurities in the first conductivity type buried regions are prevented from diffusing up to element regions of the second conductivity type. More specifically, a structure is shown in Fig. 1N of GB-2 206 446 A in which a p⁺ region is covered by a p⁻ diffusion layer and surrounded by n⁺ buried layers that are covered by n⁻ epitaxial layers.

EP-0 058 604 A1 discloses a method for manufacturing a semiconductor structure having a reduced lateral spacing between buried regions. The lateral spacing between buried regions separated by oxide-isolation regions in a semiconductor is reduced to as little as one micron by performing a deep implantation of ions of the conductivity type opposite to that of the buried regions generally into portions of the substrate below the sides where the oxide-isolation regions are formed.

The resulting device has inversion preventing regions below the field insulating film having two regions of different boron concentration.

It is the object of the present invention to provide an improved semiconductor device having a micro element structure, in which a high impurity concentration may be obtained in an inversion preventing layer to prevent a latch-up phenomenon or a field inversion phenomenon, thereby preventing a variation in characteristics of an active element.

This object is achieved by semiconductor devices having the features described in claims 1 and 3. An advantageous embodiment is described in dependent claim 2.

According to the present invention, a latch-up phenomenon or a field inversion phenomenon can be prevented by providing both p-type inversion preventing layers and n-type inversion preventing layers.

This invention can be more fully understood from the following detailed description when taken in conjunction with the accompanying drawings, in which:
Fig. 1 is a sectional view showing a conventional semiconductor device in one manufacturing step;
Fig. 2 is a view showing a profile of an impurity concentration taken along a line 2 - 2 in Fig. 1;
Fig. 3 is a view showing a profile of an impurity concentration taken along a line 3 - 3 in Fig. 1;
Figs. 4A to 4F are sectional views showing a first example not being covered by the present invention of a semiconductor device in an order of manufacturing steps;
Fig. 5 is a view showing a profile of an impurity concentration taken along a line 5 - 5 in Fig. 4B;
Figs. 6A to 6C are sectional views showing a semiconductor device according to a first embodiment of the present invention in an order of manufacturing steps;
Figs. 7A and 7B are views each showing a profile of an impurity concentration of the first embodiment of Fig. 6
Figs. 8A to 8C are sectional views showing a second example not being covered by the present invention of a semiconductor device in an order of manufacturing steps;
Fig. 9 is a view showing a profile of an impurity concentration of the device of Fig. 8;
Figs. 10A to 10C are sectional views showing a semiconductor device according to a second embodiment of the present invention in an order of manufacturing steps;
Fig. 11 is a view showing a profile of an impurity concentration of the second embodiment of Fig. 10;
Figs. 12A to 12C are sectional views showing a semiconductor device according to a third embodiment of the present invention in an order of manufacturing steps; and
Fig. 13 is a view showing a profile of an impurity concentration of the third embodiment of Fig. 12.

A first example not being covered by the present invention of a Bi-CMOS semiconductor device and a method of manufacturing the same will be described below with reference to the accompanying drawings.

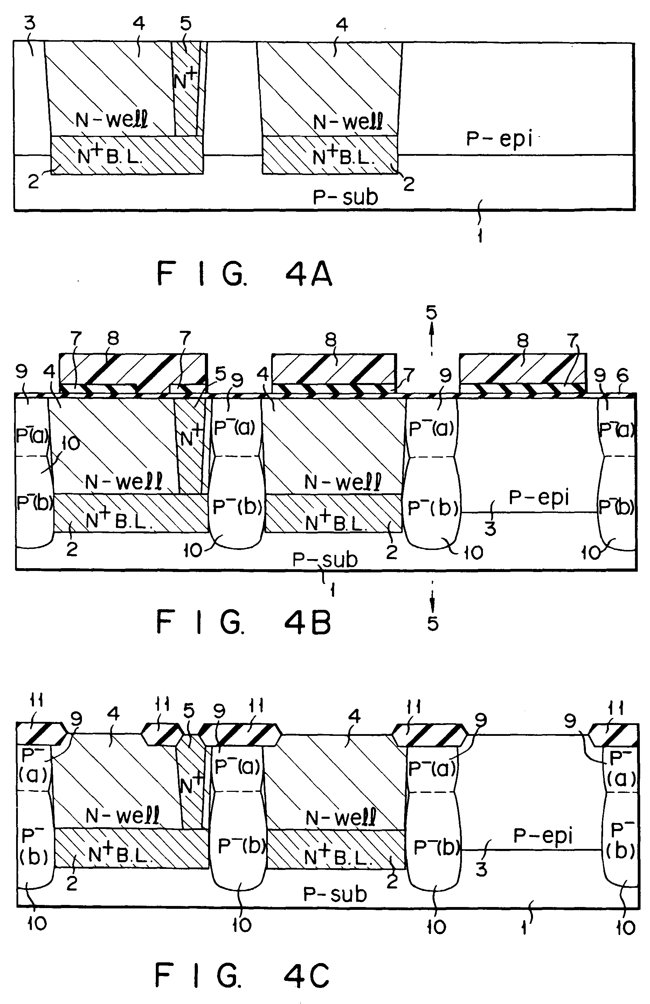

Figs. 4A to 4F are sectional views showing said semiconductor device in an order of manufacturing steps.

As shown in Fig. 4A, antimony (Sb), for example, as an n-type impurity is vapor-phase-diffused in predetermined regions on the surface of a p-type semiconductor substrate 1 having a specific resistance of about 20Ω·cm and an orientation of (100) to selectively form high-concentration n⁺-type buried layers (N⁺B.L.) 2 having a specific resistance of about 15Ω/□. A p-type epitaxial layer 3 having a specific resistance of about 4Ω·cm is formed by, e.g., a CVD method to have a thickness of about 2 µm on the substrate 1 in which the n⁺-type buried layers 2 are formed. Phosphorus (P), for example, as an n-type impurity is selectively ion-implanted in the p-type epitaxial layer 3 in correspondence with the n⁺-type buried layers 2 and thermally diffused to reach the layers 2 at a temperature of, e.g., 1,100°C, thereby forming n-type well regions 4. Phosphorus as an n-type impurity is selectively ion-implanted in a predetermined n-type well region and thermally diffused to reach the layers 2 at a temperature of, e.g., 1,100°C, thereby forming a high-concentration n⁺-type region 5 serving as a collector extraction region of a bipolar transistor.

As shown in Fig. 4A, a p-type buried layer, which is conventionally formed to serve as an inversion preventing layer, is not formed.

As shown in Fig. 4B, a thermal oxide film 6 having a thickness of about 1,000 Å is formed on the entire surface of the resultant structure by a thermal oxide method at a temperature of, e.g., 950°C. A nitride film 7 having a thickness of about 3,000 Å is formed on the entire surface of the thermal oxide film 6 by, e.g., an LPCVD method. The nitride film 7 is patterned in correspondence with formation positions of the field oxide film by, e.g., photolithography using a photoresist (not shown). A photoresist 8 is coated on the entire surface of the resultant structure and patterned by photolithography in correspondence with inversion preventing layers to be formed immediately below the field oxide film. The photoresist 8 is used as a mask to perform ion implantation of boron (B), for example, as a p-type impurity. This ion implantation is performed twice under the conditions of an acceleration voltage of 50 keV and a dose of 5 × 10¹³ cm⁻² and the conditions of an acceleration voltage of 1.5 MeV and a dose of 1 × 10¹⁴ cm⁻², thereby forming p-type inversion preventing layers 9 and 10 (P⁻(a) and P⁻(b)) in different depths. The order of the above two ion implantation operations is not particularly limited.

An impurity concentration peak of the p⁻-type inversion preventing layer 10 formed in a deeper position from the major surface of the semiconductor device is set at a position close to a boundary between the p-type semiconductor substrate 1 and the p-type epitaxial layer 3.

By setting the impurity concentration peak at the position near the boundary as described above, a satisfactory impurity concentration for forming an inversion preventing layer can be obtained from a region in the substrate 1 to a region in the epitaxial layer 3. In addition, since the n⁺-type buried layers 2 are present near the boundary, an effect of preventing punch through between the layers 2 can be further improved by locally increasing the impurity concentration of the p⁻-type inversion preventing layer 10 near the boundary.

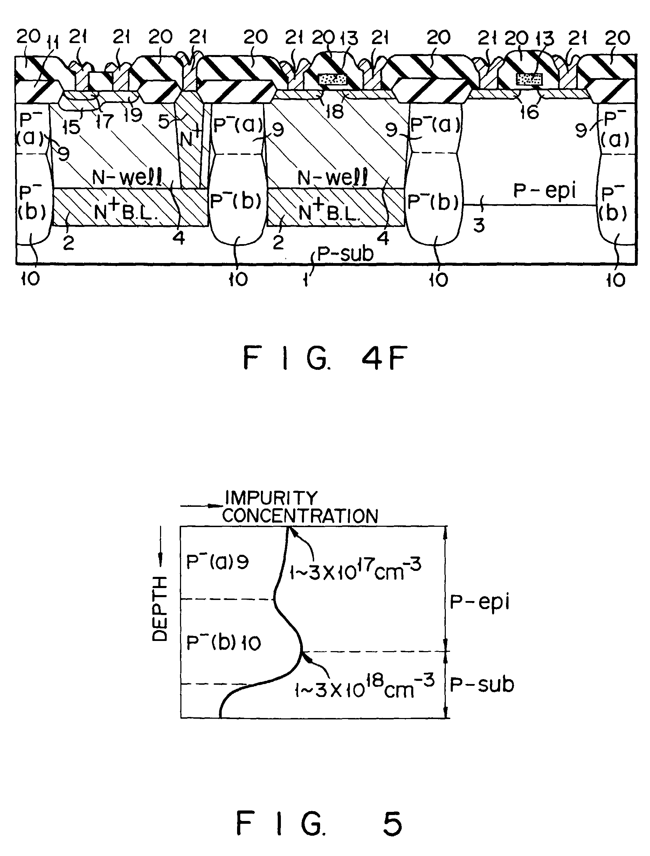

Fig. 5 is a view showing a profile of an impurity concentration taken along a line 5 - 5 in Fig. 4B. As shown in Fig. 5, an impurity concentration is about 1 × 10¹⁷ to 3 × 10¹⁷ cm⁻³ at an impurity concentration peak in the p⁻-type inversion preventing layer 9 formed near the major surface of the device. An impurity concentration is about 1 × 10¹⁸ to 3 × 10¹⁸ cm⁻³ at an impurity concentration peak in the p⁻-type inversion preventing layer 10. This peak is set in the boundary between the p-type semiconductor substrate 1 and the p-type epitaxial layer 3. The p⁻-type inversion preventing layer 10 is formed to be in contact with the n⁺-type buried layers 2. The p⁻-type inversion preventing layer 9 is formed to be in contact with the n-type well regions 4.

Note that the photoresist 8 having a high ion-implantation resistance is used as a mask during the above ion implantation. However, the same ion shield effect as that obtained by the photoresist 8 can be obtained by using an insulating layer such as a plasma oxide film having a thickness of about 3 µm as a mask.

As shown in Fig. 4C, after the photoresist 8 is removed, the nitride film 7 is used as an oxide-resistant mask to perform thermal oxidation, thereby forming a field oxide film 11 as an element isolation region having a thickness of about 8,000 Å.

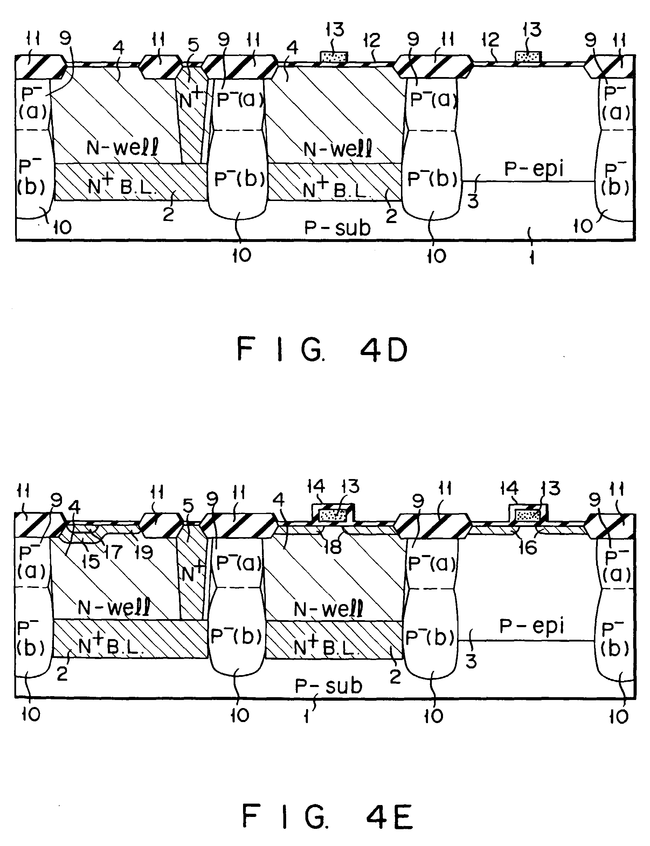

As shown in Fig. 4D, a gate oxide film 12 having a thickness of about 250 Å is formed on the surface of the element region isolated by the field oxide film 11 in an HCℓ + O₂ mixed atmosphere at a temperature of 950°C. Boron, for example, as a p-type impurity is selectively ion-implanted to control threshold values of a p⁻-type internal base formation region of a bipolar transistor and n- and p-channel MOSFETs. This boron is not shown in Fig. 4D but denoted by reference numeral 15 in Fig. 4E.

A polysilicon layer is formed on the entire surface of the resultant structure to have a thickness of about 4,000 Å by, e.g., an LPCVD method. The polysilicon layer is treated in a POCℓ₃ atmosphere at a temperature of 950°C to obtain a conductivity (n⁺type). This polysilicon layer is patterned by photolithography using a photoresist (not shown) and an RIE method to form gates 13 of MOSFETs.

As shown in Fig. 4E, wet etching using NH₄F, for example, is performed to selectively remove the gate oxide film 12 by using the gates 13 consisting of the polysilicon layer as masks, thereby temporarily exposing the element region surface. An oxide film 14 is formed on the exposed element region surface by a thermal oxide method. In this thermal oxidation, the surfaces of the gates 13 are also oxidized.

An n-type impurity, e.g., arsenic (As) is selectively ion-implanted in the n-type well regions 4 and the p-type epitaxial layer 3 to form an n⁺-type emitter region 17 of a bipolar transistor and an n⁺-type source/drain region 16 of an n-channel MOSFET. A p-type impurity, e.g., boron (B) is selectively ion-implanted in the n-type well regions 4 to form a p⁺-type source/drain region 18 of a p-channel MOSFET and a p⁺-type external base region 19 of the bipolar transistor.

As shown in Fig. 4F, an insulating interlayer 20 having a two-layered structure consisting of a CVD oxide film and a BPSG film is formed on the entire surface of the resultant structure by, e.g., an LPCVD method. The resultant structure is heat-treated in a POCℓ3 atmosphere at a temperature of, e.g., 950°C to activate the p⁻-type internal base region 15, the n⁺-type source/drain region 16, the n⁺-type emitter region 17, the p⁺-type source/drain region 18, and the p⁺-type external base region 19. As a result, desired characteristics such as a current gain h_{fe} are realized in the bipolar transistor. Contact holes are selectively formed in the insulating interlayer 20 by photolithography using a photoresist (not shown) and an RIE method. An aluminum layer 21 is formed on the entire surface including portions in the contact holes by, e.g., a sputtering method and patterned to obtain a predetermined wiring shape by photolithography using a photoresist (not shown) or the like.

The resultant structure is sintered at a temperature of, e.g., 400°C to 450°C to stabilize characteristics of the elements in the device, thereby completing this Bi-CMOS semiconductor device.

In the above first example, the impurity concentration peaks of the p⁻-type inversion preventing layers 9 and 10 present immediately below the field oxide film 11 are set to be 1 × 10¹⁷ to 3 × 10¹⁷ cm⁻³ and 1 × 10¹⁸ to 3 × 10¹⁸ cm⁻³, respectively, as described above. That is, a sufficiently high impurity concentration is obtained to increase an inversion resistance of each of the layers 9 and 10. Therefore, a latch-up phenomenon can be prevented in the p⁻-type inversion preventing layer 10 formed in contact with the n⁺-type buried layers 2.

In addition, a field inversion phenomenon can be prevented in the p⁻-type inversion preventing layer 9 present near the major surface of the device. Since the inversion resistances of the layers 9 and 10 are increased, a margin with respect to a parasitic element operation, e.g., the latch-up phenomenon or the field inversion phenomenon as described above can be improved as compared with that of a conventional CMOS or Bi-CMOS semiconductor device.

In this first example, the impurity concentration of the p⁻-type inversion preventing layer 9 is set to be 1 × 10¹⁷ to 3 × 10¹⁷ cm⁻³, and that of the p⁻-type inversion preventing layer 10 is set to be 1 × 10¹⁸ to 3 × 10¹⁸ cm⁻³. However, the impurity concentrations can be set to be higher values.

In the manufacturing method according to the above first example, after the p-type epitaxial layer 3 is formed, boron is ion-implanted as an impurity to form the p⁻-type inversion preventing layers 9 and 10 having different depths. Therefore, since a leak amount of boron having a high diffusion coefficient into the p-type epitaxial layer 3 is small, not a dull profile but a desired profile can be obtained for an impurity concentration.

As described above, a leak amount of boron as a p-type impurity for forming the p⁻-type inversion preventing layers 9 and 10 into the p-type epitaxial layer 3 is small. Therefore, even when an active element having a micro element structure is formed in the p-type epitaxial layer 3, a highly reliable active element which has small variations in various characteristics and can stably operate can be obtained.

In the above first example, the number of impurity concentration peaks in the inversion preventing layers is two. However, the number of impurity concentration peaks is not limited to that of the above first example but may be three or more.

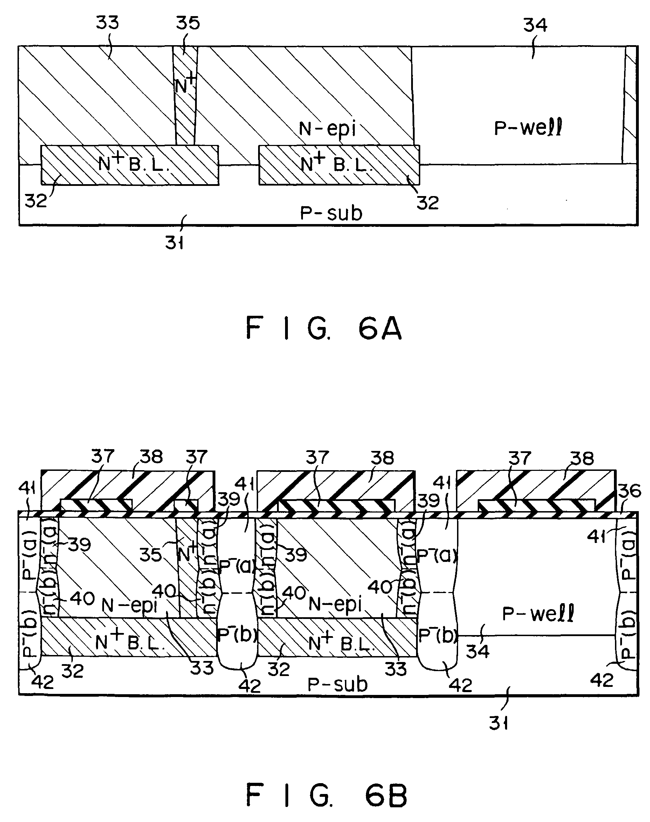

A semiconductor device according to a first embodiment of the present invention and a method of manufacturing the same will be described below with reference to Figs. 6A to 6C.

As shown in Fig. 6A, antimony, for example, as an n-type impurity is vapor-phase-diffused in predetermined regions on the surface of a p-type semiconductor substrate 31 to selectively form high-concentration n⁺-type buried layers (N⁺B.L.) 32, in the same manner as the above first example. An n-type epitaxial layer 33 is formed by, e.g., a CVD method on the p-type semiconductor substrate 31 in which the n⁺-type buried layers 32 are formed. Phosphorus, for example, as an n-type impurity is selectively ion-implanted in a predetermined position in the n-type epitaxial layer 33 and thermally diffused to reach the n⁺-type buried layers 32 and the same manner as in the first embodiment, thereby forming a high-concentration n⁺-type region 35 serving as a collector extraction region of a bipolar transistor. Boron, for example, as a p-type impurity is selectively ion-implanted in a predetermined position in the n-type epitaxial layer 33 and thermally diffused to reach the n⁺-type buried layers 32 in the same manner as in the above first example, thereby forming a high-concentration p-type well region 34.

As shown in Fig. 6B, a thermal oxide film 36 is formed on the entire surface of the resultant structure by, e.g., a thermal oxide method in the same manner as in the first embodiment. A nitride film 37 is formed on the entire surface of the thermal oxide film 36 by, e.g., an LPCVD method. The nitride film 37 is patterned by photolithography using a photoresist (not shown) to form a predetermined field oxide film. A photoresist (not shown) is coated on the entire surface of the resultant structure and patterned by photolithography in correspondence with inversion preventing layers to be formed immediately below the field oxide film. The photoresist (not shown) is used as a mask to perform ion implantation of phosphorus, for example, as an n-type impurity. This ion implantation is performed twice under the conditions of an acceleration voltage of 90 key and a dose of 5 × 10¹³ cm⁻² and the conditions of an acceleration voltage of 1.8 MeV and a dose of 1 × 10¹⁴ cm⁻², thereby forming n⁻-type inversion preventing layers 39 and 40 (N⁻(a) and N⁻(b)) in different depths. The photoresist (not shown) is removed, and a photoresist 38 is coated on the entire surface of the resultant structure and patterned by photolithography in correspondence with p⁻-type inversion preventing layers to be formed immediately below the field oxide film. The photoresist 38 which is patterned in correspondence with p⁻-type inversion preventing layers is used as a mask to perform ion implantation of boron, for example, as a p-type impurity. This ion implantation is performed twice under the conditions of an acceleration voltage of 50 keV and a dose of 5 × 10¹³ cm⁻² and the conditions of an acceleration voltage of 1.5 MeV and a dose of 1 × 10¹⁴ cm⁻², thereby forming n⁻-type inversion preventing layers 41 and 42 (P⁻(a) and P⁻(b)) in different depths. At this time, the p⁻-type inversion preventing layer 42 is formed to be in contact with, e.g., the n⁺-type buried layer 32 in the same manner as in the above first example.

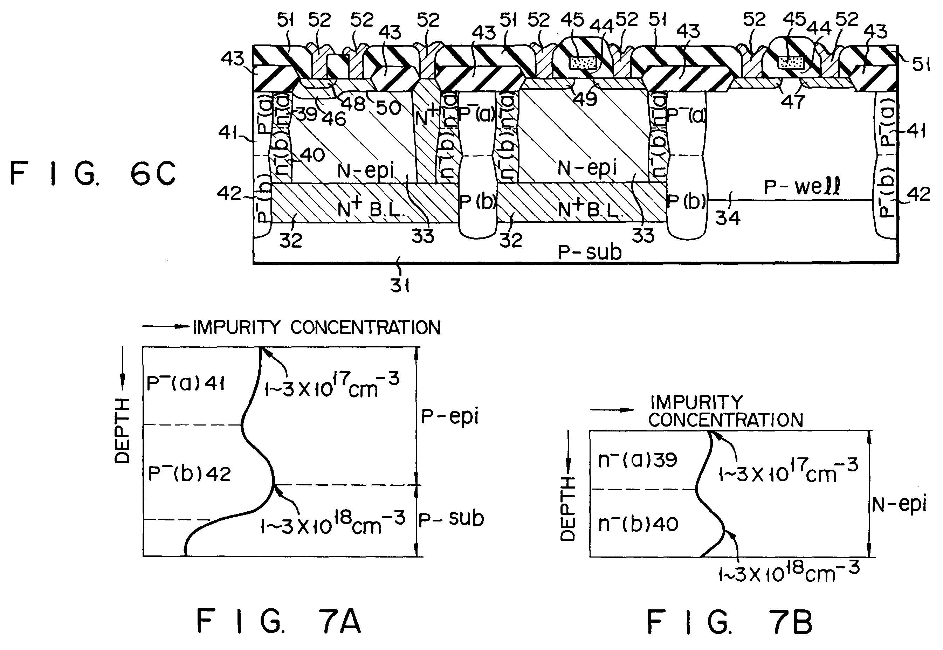

Figs. 7A and 7B show profiles of impurity concentrations of the p⁻-type inversion preventing layers 41 and 42 and the n⁻-type inversion preventing layers 39 and 40, respectively. Each impurity concentration peak in the shallower layers 39 and 41 is set to be 1 × 10¹⁷ to 3 × 10¹⁷ cm⁻³, and each impurity concentration peak in the deeper layers 40 and 42 is set to be 1 × 10¹⁸ to 3 × 10¹⁸ cm⁻³.

The order of impurity ion implantation operation for forming the n⁻-type inversion preventing layers 39 and 40 and impurity ion implantation operation for forming the p⁻-type inversion preventing layers 41 and 42 may be reversed to that of this first embodiment.

As shown in Fig. 6C, a field oxide film 43 serving as an element isolating region is formed in the same step as in the above first example. Gate oxide films 44 of MOSFETs each having a predetermined thickness are formed on the surfaces of element regions isolated by the field oxide films 43. Gates 45 of the MOSFETs made of, e.g., polysilicon and having predetermined shapes are formed. A p⁻-type internal base region 46, a p⁺-type external base region 50, and an n⁺-type emitter region 48 of a bipolar transistor, an n⁺-type source/drain region 47 of a n-channel MOSFET, and a p⁺-type source/drain region 49 of a p-channel MOSFET are respectively formed. In addition, an insulating interlayer 51 having a two-layered structure consisting a CVD oxide film and a BPSG film is formed on the entire surface of the resultant structure. Contact holes are selectively formed in the insulating interlayer 51, and wiring layers 52 made of, e.g., aluminum are formed in the holes. The resultant structure is sintered to stabilize characteristics of the elements in the device, thereby completing the Bi-CMOS semiconductor device according to this first embodiment of the present invention.

According to the above first embodiment, as in the above first example, a latch-up phenomenon or a field inversion phenomenon of the device can be prevented by the p⁻-type inversion preventing layers 41 and 42 and the n⁻-type inversion preventing layers 39 and 40 each having a sufficiently high impurity concentration, and a margin with respect to a parasitic element operation can be improved.

In addition, p⁻-type inversion preventing layers 41 and 42 are formed by performing ion implantation of boron twice after the n-type epitaxial layer 33 and the p-type well region 34 are formed. Therefore, even when the inversion preventing layers 41 and 42 are formed by ion-implanting boron serving as a p-type impurity having a high diffusion coefficient as in the above first example, not a dull profile but a desired profile can be obtained for an impurity concentration.

Furthermore, a leak amount of boron into the n-type epitaxial layer 33 is small. Therefore, even when an active element having a micro element structure is formed in the n-type epitaxial layer 33, a highly reliable active element which has small variations in various characteristics and can stably operate can be obtained.

In the above first embodiment, the number of impurity concentration peaks in the p⁻-type or n⁻-type inversion preventing layers (39 to 42) is two. However, the number of impurity concentration peaks is not limited to that of the above first embodiment but may be three or more.

The number of ion-implantation operations of an impurity for forming an inversion preventing layer is two. However, the number of ion-implantation operations is not limited to that of the above first embodiment but may be three or more.

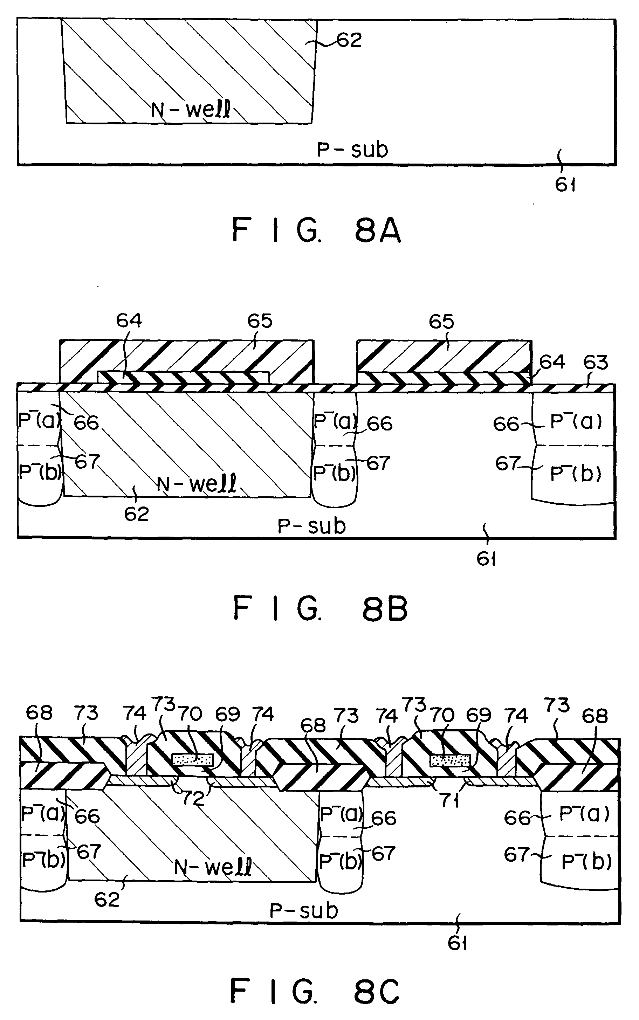

A second example not being covered by the present invention of a semiconductor device and a method of manufacturing the same will be described below with reference to Figs. 8A to 8C. This second example explains a case wherein a semiconductor device has an epitaxial layer on a semiconductor substrate.

As shown in Fig. 8A, phosphorus, for example, as an n-type impurity is selectively ion-implanted in a predetermined position of a p-type semiconductor substrate 61 and thermally diffused, thereby forming an n-type well region 62.

As shown in Fig. 8B, a thermal oxide film 63 is formed on the entire surface of the p-type semiconductor substrate 61 and the n-type well region 62 by, e.g., a thermal oxide method. A nitride film 64 is formed on the entire surface of the resultant structure by, e.g., an LPCVD method. The nitride film 64 is patterned into a predetermined field oxide film forming pattern by photolithography using a photoresist (not shown). A photoresist 65 is coated on the entire surface of the resultant structure and patterned by photolithography in correspondence with p⁻-type inversion preventing layers to be formed immediately below the field oxide film. The photoresist 65 is used as a mask to perform ion implantation of boron, for example, as a p-type impurity. This ion implantation is performed twice under the conditions of an acceleration voltage of 50 keV and a dose of 5 × 10¹³ cm⁻² and the conditions of an acceleration voltage of 1.5 MeV and a dose of 1 × 10¹⁴ cm⁻², thereby forming p⁻-type inversion preventing layers 66 and 67 in different depths. At this time, the p⁻-type inversion preventing layers 66 and 67 are formed to be into contact with, e.g., the n-type well region 62.

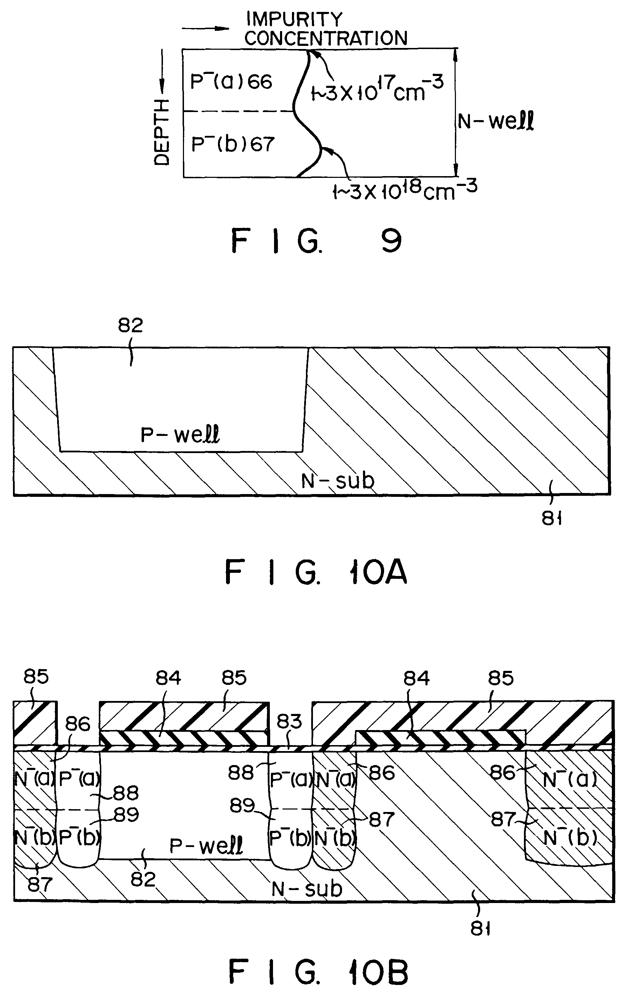

Fig. 9 shows profiles of impurity concentrations of the inversion preventing layers 66 and 67. An impurity concentration peak in the shallower inversion preventing layer 66 is set to be 1 × 10¹⁷ cm⁻³ to 3 × 10¹⁷, and an impurity concentration peak in the deeper inversion preventing layer 67 is set to be 1 × 10¹⁸ to 3 × 10¹⁸ cm⁻³.

As shown in Fig. 8C, a field oxide film 68 serving as an element isolating region is formed in the same manner as in the above second example and first embodiment. Gate oxide films 69 of MOSFETs each having a predetermined thickness are formed on the surfaces of the element regions isolated by the field oxide film 68. Gates 70 of the MOSFETs made of, e.g., polysilicon and having predetermined shapes are formed. An n⁺-type source/drain region 71 of the n-channel MOSFET and a p⁺-type source/drain region 72 of the p-channel MOSFET are formed. An insulating interlayer 73 having a two-layered structure consisting, e.g., a CVD oxide film and a BPSG film is formed on the entire surface of the resultant structure. Contact holes are selectively formed in the insulating interlayer 73, and wiring layers 74 made of, e.g., aluminum are formed in the holes. The resultant structure is sintered to stabilize characteristics of the elements in the device, thereby completing this second example of a CMOS semiconductor device.

According to the above second example, as in the above the first embodiment and first example, a latch-up phenomenon or a field inversion phenomenon of the device can be prevented by the p⁻-type inversion preventing layers 66 and 67 each having a sufficiently high impurity concentration, and a margin with respect to a parasitic element operation can be improved.

In addition, p⁻-type inversion preventing layers 66 and 67 are formed by performing ion implantation of boron twice. Therefore, even when the inversion preventing layers 66 and 67 are formed by ion-implanting boron serving as a p-type impurity having a high diffusion coefficient, not a dull profile but a desired profile can be obtained for an impurity concentration.

In a conventional method, in order to form a p-type inversion preventing layer in a deeper position from the surface of the semiconductor device as described in the above second example, a p-type buried layer must be formed on the surface of the semiconductor substrate, and then an epitaxial layer must be formed. However, according to the above second example, a p-type inversion preventing layer can be formed in a deeper position from the surface of the semiconductor device without forming an epitaxial layer, thereby reducing a manufacturing cost.

Furthermore, since the p⁻-type inversion preventing layers 66 and 67 are formed after formation of the n-type well region 62, a leak amount of boron, for example, as a p-type impurity is small. Therefore, even when an active element having a micro element structure is formed in the p-type semiconductor substrate 61, a highly reliable active element which has small variations in various characteristics and can stably operate can be obtained.

In the above second example, the number of impurity concentration peaks in the p⁻-type inversion preventing layers 66 and 67 is two. However, the number of impurity concentration peaks is not limited to that of the above second example but may be three or more.

The number of ion-implantation operations of an impurity for forming an inversion preventing layer is two. However the number of ion-implantation operations is not limited to that of the above second example but may be three or more.

A semiconductor device according to a second embodiment of the present invention and a method of manufacturing the same will be described below with reference to Figs. 10A to 10C.

As shown in Fig. 10A, boron, for example, as a p-type impurity is selectively ion-implanted in a predetermined position of an n-type semiconductor substrate 81 and thermally diffused, thereby forming a p-type well region 82.

As shown in Fig. 10B, a thermal oxide film 83 is formed on the entire surface of the n-type semiconductor substrate 81 and the p-type well region 82 by, e.g., a thermal oxide method. A nitride film 84 is formed on the entire surface of the resultant structure by, e.g., an LPCVD method. The nitride film 84 is patterned by photolithography using a photoresist (not shown) to form a predetermined field oxide film. A photoresist (not shown) is coated on the entire surface of the resultant structure and patterned by photolithography in correspondence with n⁻-type inversion preventing layers to be formed immediately below the field oxide film. The photoresist is used as a mask to perform ion implantation of phosphorus, for example, as an n-type impurity. This ion implantation is performed twice under the conditions of an acceleration voltage of 90 key and a dose of 5 × 10¹³ cm⁻² and the conditions of an acceleration voltage of 1.5 MeV and a dose of 5 × 10¹⁴ cm⁻², thereby forming n⁻-type inversion preventing layers 86 and 87 (N⁻(a), N⁻(b)) in different depths. The photoresist (not shown) is removed, and a photoresist 85 is coated on the entire surface of the resultant structure again and patterned by photolithography to form p⁻-type inversion preventing layers so as to be in contact with the n⁻-type inversion preventing layers 86 and 87 immediately below the field oxide film. The photoresist 85 which is patterned in correspondence with p⁻-type inversion preventing layers is used as a mask to perform ion implantation of boron, for example, as a p-type impurity. This ion implantation is performed twice under the conditions of an acceleration voltage of 50 keV and a dose of 8 × 10¹³ cm⁻² and the conditions of an acceleration voltage of 1.5 MeV and a dose of 1 × 10¹⁴ cm⁻², thereby forming p⁻-type inversion preventing layers 88 and 89 (P⁻(a) and P⁻(b)) in different depths. At this time, the p⁻-type inversion preventing layers 88 and 89 are formed to be in contact with the n⁺-type buried layers 86 and 87, respectively.

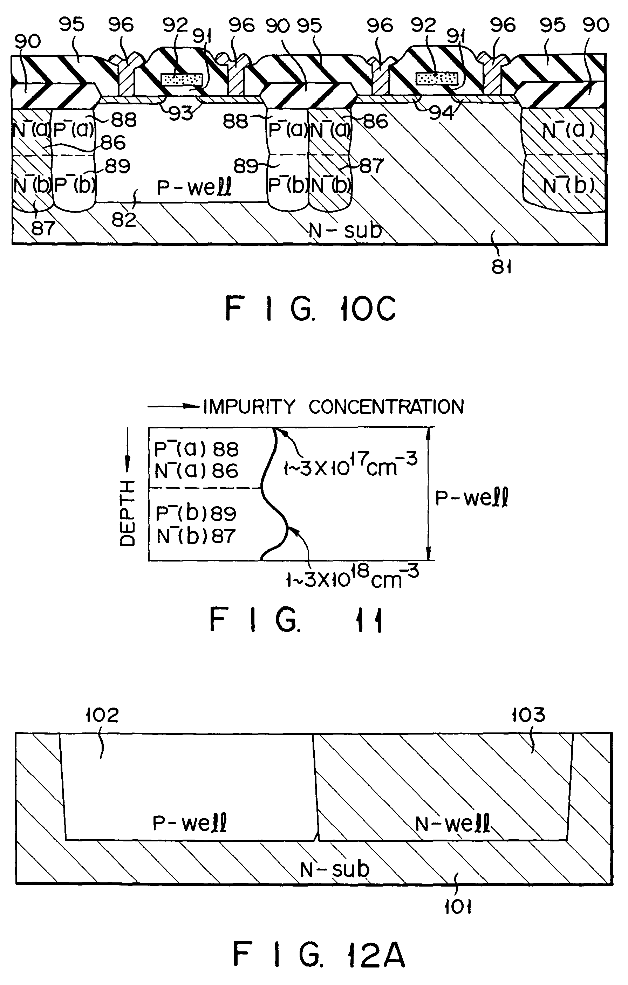

Fig. 11 shows profiles of impurity concentrations of the n⁻-type inversion preventing layers 86 and 87 and the p⁻-type inversion preventing layers 88 and 89. An impurity concentration peak in the shallower inversion preventing layers 86 and 88 is set to be 1 × 10¹⁷ cm⁻³ to 3 × 10¹⁷, and an impurity concentration peak in the deeper inversion preventing layers 87 and 89 is set to be 1 × 10¹⁸ to 3 × 10¹⁸ cm-3.

Note that the order of the ion implantation operation for forming the n⁻-type inversion preventing layers 86 and 87 and the ion implantation operation for forming the p⁻-type inversion preventing layers 88 and 89 may be reversed to that of this second embodiment.

As shown in Fig. 10C, a field oxide film 90 serving as an element isolating region is formed on the inversion preventing layers 86 and 88 in the same manner as in the first embodiment and the above first and second examples. Gate oxide films 91 of MOSFETs each having a predetermined thickness are formed on the surfaces of the element regions isolated by the field oxide film 90. Gates 92 of the MOSFETs made of, e.g., polysilicon and having predetermined shapes are formed. An n⁺-type source/drain region 93 of the n-channel MOSFET and a p⁺-type source/drain region 93 of the n-channel MOSFET are formed. An insulating interlayer 95 having a two-layered structure consisting, e.g., a CVD oxide film and a BPSG film is formed on the entire surface of the resultant structure. Contact holes are selectively formed in the insulating interlayer 95, and wiring layers 96 made of, e.g., aluminum are formed in the holes. The resultant structure is sintered to stabilize characteristics of the elements in the device, thereby completing the CMOS semiconductor device according to this second embodiment of the present invention.

According to the above second embodiment of the invention, as in the first embodiment and the above first and second examples, a latch-up phenomenon or a field inversion phenomenon of the device can be prevented by the p⁻-type inversion preventing layers 88 and 89 and the n⁻-type inversion preventing layers 86 and 87 each having a sufficiently high impurity concentration, and a margin with respect to a parasitic element operation can be improved.

In addition, p⁻-type inversion preventing layers 88 and 89 are formed by performing ion implantation of boron twice. Therefore, even when the inversion preventing layers 88 and 89 are formed by ion-implanting boron having a high diffusion coefficient, not a dull profile but a desired profile can be obtained for an impurity concentration.

In addition, even when a p-type inversion preventing layer is formed in a deeper position from the surface of the semiconductor device as described in the above second example of Fig. 8, an epitaxial layer need not be formed, thereby reducing a manufacturing cost.

Furthermore, since the p⁻-type inversion preventing layers 88 and 89 are formed after formation of the p-type well region 82, a leak amount of boron, for example, as a p-type impurity is small. Therefore, even when an active element having a micro element structure is formed in the p-type semiconductor substrate 81, a highly reliable active element which has small variations in various characteristics and can stably operate can be obtained.

At this time, the p⁻-type inversion preventing layers 88 and 89 are formed to be in contact with, e.g., the n⁻-type inversion preventing layers 86 and 87.

Note that, in a semiconductor device according to the second embodiment of the invention and a method of manufacturing the same, the number of impurity concentration peaks in the p⁻-type inversion preventing layers 88 and 89 or in the n⁻-type inversion preventing layers 86 and 87 is two. However, the number of impurity concentration peaks is not limited to that of the above second embodiment of the invention but may be three or more.

The number of ion-implantation operations of an impurity for forming an inversion preventing layer is two. However the number of ion-implantation operations is not limited to that of the above second embodiment of the invention but may be three or more.

A semiconductor device according to a third embodiment of the invention and a method of manufacturing the same will be described below with reference to Figs. 12A to 12C.

As shown in Fig. 12A, boron, for example, as a p-type impurity is selectively ion-implanted in a predetermined position of an n-type semiconductor substrate 101 and thermally diffused, thereby forming a p-type well region 102. Phosphorus as an n-type impurity is selectively ion-implanted in a predetermined position of an n-type semiconductor substrate 101 and thermally diffused to form an n-type well region 103. This structure is called a twin tub or a twin well.

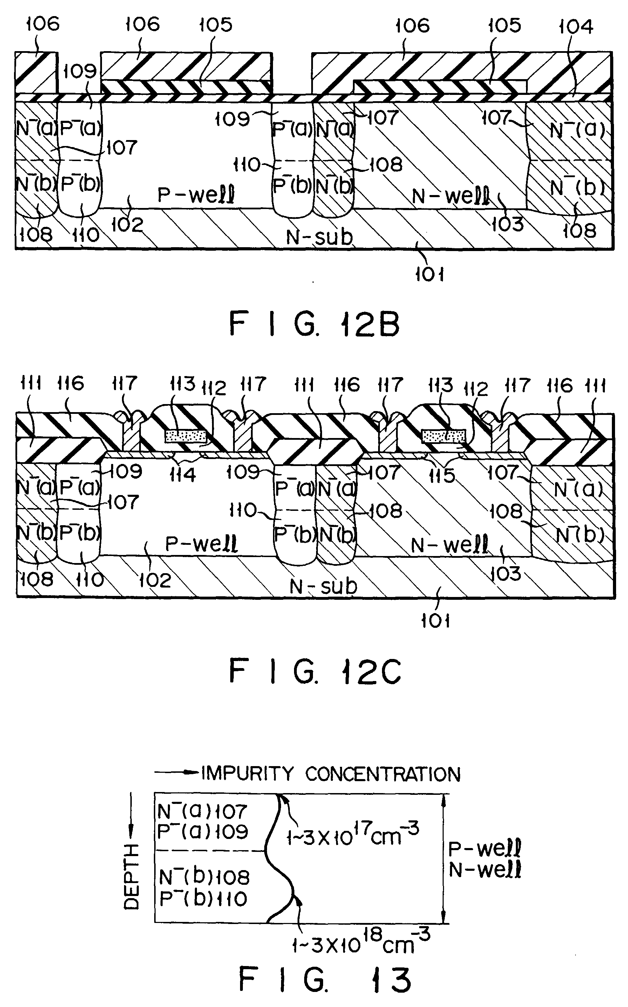

As shown in Fig. 12B, a thermal oxide film 104 is formed on the entire surface of the resultant structure by, e.g., a thermal oxide method. A nitride film 105 is formed on the entire surface of the thermal oxide film 104 by, e.g., an LPCVD method. The nitride film 105 is patterned by photolithography using a photoresist (not shown) to form a predetermined field oxide film. A photoresist (not shown) is coated on the entire surface of the resultant structure and patterned by photolithography in correspondence with n⁻-type inversion preventing layers to be formed immediately below the field oxide film. The photoresist is used as a mask to perform ion implantation of phosphorus, for example, as an n-type impurity. This ion implantation is performed twice under the conditions of an acceleration voltage of 90 keV and a dose of 5 × 10¹³ cm⁻² and the conditions of an acceleration voltage of 1.5 MeV and a dose of 5 × 10¹⁴ cm⁻², thereby forming n⁻-type inversion preventing layers 107 and 108 (N⁻(a), N⁻(b)) in different depths. The photoresist (not shown) is removed, and a photoresist 106 is coated on the entire surface of the resultant structure again and patterned by photolithography to form p⁻-type inversion preventing layers so as to be in contact with the n⁻-type inversion preventing layers 107 and 108 immediately below the field oxide film. The photoresist 106 which is patterned is used as a mask to perform ion implantation of boron, for example, as a p-type impurity. This ion implantation is performed twice under the conditions of an acceleration voltage of 50 keV and a dose of 8 × 10¹³ cm⁻² and the conditions of an acceleration voltage of 1.5 MeV and a dose of 1 × 10¹⁴ cm⁻², thereby forming p⁻-type inversion preventing layers 109 and 110 (P⁻(a) and P⁻(b)) in different depths. At this time, the p⁻-type inversion preventing layers 109 and 110 are formed to be in contact with, e.g., n⁻-type buried layers 107 and 108, respectively.

Fig. 13 shows profiles of impurity concentrations of the inversion preventing layers 107 and 108 and the p⁻-type inversion preventing layers 109 and 110. An impurity concentration peak in the shallower inversion preventing layers 107 and 109 is set to be 1 × 10¹⁷ cm⁻³ to 3 × 10¹⁷, and an impurity concentration peak in the deeper p⁻-type inversion preventing layers 108 and 110 is set to be 1 × 10¹⁸ to 3 × 10¹⁸ cm⁻³.

Note that the order of the ion implantation operation for forming the n⁻-type inversion preventing layers 107 and 108 and the ion implantation operation for forming the p⁻-type inversion preventing layers 109 and 110 may be reversed to that of this third embodiment of the invention.

As shown in Fig. 12C, a field oxide film 111 serving as an element isolating region is formed in the same manner as in the first and second embodiments of the invention and first and second examples. Gate oxide films 112 of MOSFETs each having a predetermined thickness are formed on the surfaces of the element regions isolated by the field oxide film 111. Gates 113 of the MOSFETs made of, e.g., polysilicon and having predetermined shapes are formed. An n⁺-type source/drain region 114 of the n-chennel MOSFET and a p⁺-type source/drain region 115 of the p-channel MOSFET are formed. An insulating interlayer 116 having a two-layered structure consisting, e.g., a CVD oxide film and a BPSG film is formed on the entire surface of the resultant structure. Contact holes are selectively formed in the insulating interlayer 116, and wiring layers 117 made of, e.g., aluminum are formed in the holes. The resultant structure is sintered to stabilize characteristics of the elements in the device, thereby completing the CMOS semiconductor device according to the third embodiment of the present invention.

According to this third embodiment of the invention, as in the first and second embodiments and examples, a latch-up phenomenon or a field inversion phenomenon of the device can be prevented by the p⁻-type inversion preventing layers 109 and 110 and the n⁻-type inversion preventing layers 107 and 108 each having a sufficiently high impurity concentration, and a margin with respect to a parasitic element operation can be improved.

In addition, p⁻-type inversion preventing layers 109 and 110 are formed by performing ion implantation of boron twice. Therefore, even when the inversion preventing layers 109 and 110 are formed by ion-implanting boron serving as a p-type impurity having a high diffusion coefficient, not a dull profile but a desired profile can be obtained for an impurity concentration.

In addition, even when a p-type inversion preventing layer is formed in a deeper position from the surface of the semiconductor device as described in the second example and the second embodiment of the present invention, in connection with Figs. 8 and 10, an epitaxial layer need not be formed, thereby reducing a manufacturing cost. Furthermore, since the p⁻-type inversion preventing layers 109 and 110 are formed after formation of the p-type n-type well regions 102 and 103, a leak amount of boron, for example, as a p-type impurity is small. Therefore, even when an active element having a micro element structure is formed in the n-type semiconductor substrate 101, a highly reliable active element which has small variations in various characteristics and can stably operate can be obtained.

Note that, in the third embodiment of the present invention, the number of impurity concentration peaks in the p⁻-type inversion preventing layers 109 and 110 or in the n⁻-type inversion preventing layers 107 and 108 is two. However, the number of impurity concentration peaks is not limited to that of the above third embodiment of the present invention but may be three or more.

The number of ion-implantation operations of an impurity for forming an inversion preventing layer is two. However, the number of ion-implantation operations is not limited to that of the above third embodiment of the present invention but may be three or more.

The present invention can be effectively applied especially to a Bi-CMOS semiconductor device or a CMOS semiconductor device. However, the present invention may be applied as a countermeasure against field inversion or latch-up in various semiconductor devices without being limited to the above semiconductor devices. For example, the present invention can be effectively applied to an analog/digital integrated semiconductor device consisting of bipolar transistors, a hybrid semiconductor device consisting of a charge transfer device and a CMOS, or the like.

Reference signs are added to the claims for reference purposes only and do not limit the scope.

## Claims

1. A semiconductor device comprising:
a semiconductor substrate (81) of a first conductivity type;
a well region (82) of a second conductivity type formed in said semiconductor substrate (81);
a field insulating film (90) formed on a surface region of said semiconductor substrate (81);
active elements (92, 93, 94) formed in said semiconductor substrate, (81) isolated by said field insulating film (90) and in said well region (82); and
first inversion preventing regions (86, 87) of the first conductivity type and second inversion preventing regions (88, 89) of the second conductivity type formed substantially immediately below said field insulating film (90), said first inversion preventing regions (86, 87) being formed in said semiconductor substrate, said second inversion preventing regions (88, 89) being formed on the sides of the first inversion preventing regions and in contact with the well region (82), the regions of each conductivity type having a plurality of impurity concentration peaks formed by ion implantation in a direction of depth; and a value of an impurity concentration of the deeper inversion preventing regions being set to be higher than that of shallower inversion preventing regions.

2. A device according to claim 1, characterized in that an impurity concentration peak in a shallower region of said inversion preventing regions (86, 87, 88, 89) is set to be 1 x 10¹⁷ to 3 x 10¹⁷ cm⁻³ and an impurity concentration peak in a deeper layer thereof is set to be 1 x 10¹⁸ to 3 x 10¹⁸ cm⁻³.

3. A semiconductor device comprising:
a semiconductor substrate (31) of a first conductivity type;
buried regions (32) of a second conductivity type formed in a plurality of portions on a surface region of said semiconductor substrate (31);
an epitaxial layer (33) of the second conductivity type formed on said buried regions (32) and said semiconductor substrate (31);
a well region (34) of the first conductivity type formed in said epitaxial layer (33) so as to be in contact with said semiconductor substrate (31);
active elements (44, 47, 49, 46, 48) formed in said epitaxial layer (33) and in said well region (34);
a region (35) of the second conductivity type with a high impurity concentration formed in said epitaxial layer (33) so as to be in contact with one of said buried regions (32);
a field insulating film (43) formed on a surface region of said epitaxial layer (33);
first inversion preventing regions (41, 42) of the first conductivity type and second inversion preventing layers (39, 40) of the second conductivity type formed substantially immediately below said field insulating film (43), said second inversion preventing regions being formed on the sides of the first inversion preventing regions, and in contact with said epitaxial layer (33) and said buried regions (32) the inversion preventing regions of each conductivity type having a plurality of impurity concentration peaks formed by ion implantation and a value of an impurity concentration of the deeper inversion preventing regions is set to be higher than that of shallower inversion preventing regions.

## Patentansprüche

1. Halbleitervorrichtung, umfassend:
ein Halbleitersubstrat (81) eines ersten Leitfähigkeitstyps;
ein Wannengebiet (82) eines zweiten Leitfähigkeitstyps, das in dem Halbleitersubstrat (81) gebildet ist;
eine Feldisolierschicht (90), die auf einem Oberflächengebiet des Halbleitersubstrats (81) gebildet ist;
aktive Elemente (92, 93, 94), die in dem Halbleitersubstrat (81) gebildet sind, isoliert durch die Feldisolierschicht (90) und in dem Wannengebiet (82); und
erste Inversionsverhinderungs-Gebiete (86, 87) des ersten Leitfähigkeitstyps und zweite Inversionsverhinderungs-Gebiete (88, 89) des zweiten Leitfähigkeitstyps, die im wesentlichen unmittelbar unter der Feldisolierschicht (90) gebildet sind, wobei die ersten Inversionsverhinderungs-Gebiete (86, 87) in dem Halbleitersubstrat gebildet sind, die zweiten Inversionsverhinderungs-Gebiete (88, 89) an den Seiten der ersten Inversionsverhinderungs-Gebiete und in Kontakt mit dem Wannengebiet (82) gebildet sind, die Gebiete jeden Leitfähigkeitstyps eine Vielzahl von Dotierstoff-Konzentrationsspitzen haben, die durch Ionenimplantation in eine Tiefenrichtung gebildet sind, und ein Wert einer Dotierstoff-Konzentration der tieferen Inversionsverhinderungs-Gebiete höher eingestellt ist als jener der flacheren Inversionsverhinderungs-Gebiete.

2. Vorrichtung nach Anspruch 1, dadurch gekennzeichnet, dass eine Dotierstoff-Konzentrationsspitze in einem flacheren Gebiet der Inversionsverhinderungs-Gebiete (86, 87, 88, 89) eingestellt ist auf 1 x 10¹⁷ bis 3 x 10¹⁷ cm⁻³, und eine Dotierstoff-Konzentrationsspitze in einer tieferen Schicht eingestellt ist auf 1 x 10¹⁸ bis 3 x 10¹⁸ cm⁻³.

3. Halbleitervorrichtung, umfassend:
ein Halbleitersubstrat (31) eines ersten Leitfähigkeitstyps;
vergrabene Gebiete (32) eines zweiten Leitfähigkeitstyps, die in einer Vielzahl von Abschnitten auf einem Oberflächengebiet des Halbleitersubstrat (31) gebildet sind;
eine Epitaxieschicht (33) des zweiten Leitfähigkeitstyps, die auf den vergrabenen Gebieten (32) und dem Halbleitersubstrat (31) gebildet ist;
ein Wannengebiet (34) des ersten Leitfähigkeitstyps, das in der Epitaxieschicht (33) gebildet ist, um in Kontakt mit dem Halbleitersubstrat (31) zu sein;
aktive Elemente (44, 47, 49, 46, 48), die in der Epitaxieschicht (33) und dem Wannengebiet (34) gebildet sind;
ein Gebiet (35) des zweiten Leitfähigkeitstyps mit einer hohen Dotierstoff-Konzentration, das in der Epitaxieschicht (33) gebildet ist, um in Kontakt zu sein mit einem der vergrabenen Gebiete (32);
eine Feldisolierschicht (43) die auf einem Oberflächengebiet der Epitaxieschicht (33) gebildet ist;
erste Inversionsverhinderungs-Gebiete (41, 42) des ersten Leitfähigkeitstyps und zweite Inversionsverhinderungs-Schichten (39, 40) des zweiten Leitfähigkeitstyps, die im wesentlichen unmittelbar unter der Feldisolierschicht (43) gebildet sind, wobei die zweiten Inversionsverhinderungs-Gebiete an den Seiten der ersten Inversionsverhinderungs-Gebiete gebildet sind, und in Kontakt mit der Epitaxieschicht (33) und den vergrabenen Gebieten (32), die Inversionsverhinderungs-Gebiete jedes Leitfähigkeitstyps eine Vielzahl von Dotierstotf-Konzentrationsspitzen haben, die durch Ionenimplantation gebildet sind, und ein Wert einer Dotierstoff-Konzentration der tieferen Inversionsverhinderungs-Gebiete höher eingestellt ist als jener der flacheren.

## Revendications

1. Dispositif à semiconducteur comprenant :
un substrat semiconducteur (81) d'un premier type de conductivité ;
une région de puits (82) d'un second type de conductivité formée dans ledit substrat semiconducteur (81) ;
un film d'isolation de champ (90) formé sur une région de surface dudit substrat semiconducteur (81) ;
des éléments actifs (92, 93, 94) formés dans ledit substrat semiconducteur (81) isolé par ledit film d'isolation de champ (90) et dans ladite région de puits (82) ; et
des premières régions d'empêchement d'inversion (86, 87) du premier type de conductivité et des secondes régions d'empêchement d'inversion (88, 89) du second type de conductivité formées sensiblement immédiatement au-dessous dudit film d'isolation de champ (90), lesdites premières régions d'empêchement d'inversion (86, 87) étant formées dans ledit substrat semiconducteur, lesdites secondes régions d'empêchement d'inversion (88, 89) étant formées sur les côtés des premières régions d'empêchement d'inversion et en contact avec la région de puits (82), les régions de chaque type de conductivité présentant une pluralité de crêtes de concentration en impureté formées par une implantation ionique suivant une direction de profondeur ; et une valeur d'une concentration en impureté dans les régions d'empêchement d'inversion plus profondes étant établie de manière à être supérieure à celle de régions d'empêchement d'inversion moins profondes.

2. Dispositif selon la revendication 1, caractérisé en ce qu'une crête de concentration en impureté dans une région moins profonde desdites régions d'empêchement d'inversion (86, 87, 88, 89) est établie de manière à valoir 1 x 10¹⁷ à 3 x 10¹⁷ cm⁻³ et une crête de concentration en impureté dans sa couche plus profonde est établie de manière à valoir 1 x 10¹⁸ à 3 x 10¹⁸ cm⁻³.

3. Dispositif à semiconducteur comprenant:
un substrat semiconducteur (31) d'un premier type de conductivité ;
des régions enterrées (32) d'un second type de conductivité formées dans une pluralité de parties sur une région de surface dudit substrat semiconducteur (31) ;
une couche épitaxiale (33) du second type de conductivité formée sur lesdites régions enterrées (32) et ledit substrat semiconducteur (31) ;
une région de puits (34) du premier type de conductivité formée dans ladite couche épitaxiale (33) de manière à être en contact avec ledit substrat semiconducteur (31) ;
des éléments actifs (44, 47, 49, 46, 48) formés dans ladite couche épitaxiale (33) et dans ladite région de puits (34) ;
une région (35) du second type de conductivité présentant une concentration en impureté élevée formée dans ladite couche épitaxiale (33) de manière à être en contact avec l'une desdites régions enterrées (32) ;
un film d'isolation de champ (43) formé sur une région de surface de ladite couche épitaxiale (33) ;
des premières régions d'empêchement d'inversion (41, 42) du premier type de conductivité et des secondes couches d'empêchement d'inversion (39, 40) du second type de conductivité formées sensiblement immédiatement au-dessous dudit film d'isolation de champ (43), lesdites secondes régions d'empêchement d'inversion étant formées sur les côtés des premières régions d'empêchement d'inversion et en contact avec ladite couche épitaxiale (33) et avec lesdites régions enterrées (32), les régions d'empêchement d'inversion de chaque type de conductivité présentant une pluralité de crêtes de concentration en impureté formées par une implantation ionique et une valeur d'une concentration en impureté des régions d'empêchement d'inversion plus profondes étant établie de manière à être supérieure à celle de régions d'empêchement d'inversion moins profondes.
